# EUROPÄISCHE PATENTANMELDUNG

(11) **EP 4 481 776 A1**
(43) Veröffentlichungstag der Anmeldung: **25.12.2024**
(21) Anmeldenummer: 23180856.9
(22) Anmeldetag: 22.06.2023
(51) Int. Cl.: H01G 4/33, H01G 7/02, H02S 99/00, H01G 4/008, H01G 7/06, H01G 4/12, G21H 1/06, H10B 53/00

(54) **VERFAHREN ZUR HERSTELLUNG EINES UMGEBUNGSENERGIE-WANDLERS, INSBESONDERE EINES UMGEBUNGSENERGIEELEKTRISCHEN ELEMENTS**

(71) Anmelder: E-Convert GmbH, 51427 Bergisch Gladbach (DE)
(72) Erfinder: LINDEN, Olaf, 51427 Bergisch Gladbach (DE); SHUMINSKYY, Gernrik G., 74800 Kherson region (UA); HETMAN, Oleksandr I., 74800 Kherson region (DE)
(74) Vertreter: Jeck, Jonathan

(57) **Zusammenfassung**

Es wird ein Verfahren zur Herstellung eines Umgebungsenergiewandlers umfassend ein plattenförmiges Trägersubstrat aus einem ersten Leitermaterial als erste Elektrode und einen auf dieser angeordneten Schichtaufbau mit einer Schicht ferroelektrischen Materials und einer Schicht eines von dem ersten Leitermaterial verschiedenen zweiten Leitermaterials als zweite Elektrode beschrieben. Die beiden Leitermaterialien weisen unterschiedliche Konzentrationen freier Elektronen auf. Das ferroelektrische Material umfasst einen oder mehrere ferroelektrische Halbleiter. Ferroelektrische Halbleiter, die als ferroelektrisches Material verwendet werden, sind aus der Liste von Natriumnitrit, Halbleiterkeramiken auf Basis von Bariumtitanat, Lithiumniobat, Kaliumniobat, Bleititanat, etc. ausgewählt. Das Verfahren umfasst die Verfahrensschritte:
- Bereitstellung einer Platte aus dem für die erste Elektrode vorgesehenen Leitermaterial als Trägersubstrat,
- Unterziehung des Trägersubstrats mindestens einer Oberflächenbehandlung,
- Auftragen der Schicht ferroelektrischen Materials (BTO-Schicht), auf eine als Vorderseite vorgesehene Seite des Trägersubstrats,
- Maskierung zumindest der Ränder der BTO-Schicht auf der Vorderseite des Trägersubstrats unter Freihaltung mindestens einer innerhalb der Ränder der BTO-Schicht befindlichen Partie, und
- Auftragen des für die zweite Elektrode vorgesehenen Leitermaterials auf die von der Maskierung freigehaltene Partie.

## Beschreibung

Die Erfindung betrifft ein Verfahren zur Herstellung eines Umgebungsenergie-Wandlers gemäß dem Oberbegriff des Anspruchs 1. Insbesondere betrifft die Erfindung ein umgebungsenergieelektrisches Element - vulgo ein Elektrizität aus Umgebungsenergie schöpfendes Element - und ein zu dessen Herstellung geeignetes Verfahren.

Das Funktionsprinzip des auch als Umweltenergiewandler bezeichneten Umgebungsenergie-Wandlers ist der Betrieb des Geräts aufgrund der Aufnahme von Energie aus der Umgebung in dem Bereich, in dem sich dieses Gerät befindet.

Die im Gerät verwendeten Materialien, die Möglichkeit, sie zu kombinieren, sowie die Möglichkeit, den Materialanteil zu ändern, und die Möglichkeit, das Design des Geräts entsprechend der technischen Aufgabe zu ändern ermöglicht es, das Gerät universell in verschiedenen Anwendungen einzusetzen, die eine Stromversorgung benötigen.

Durch WO 2017/184102 A1 ist ein elektrischer Stromumwandler bekannt. Dieser besteht aus einem Gehäuse mit einem Paket aus leitenden Platten beider Merkmale, einschließlich mindestens einer Elementarzelle. Die Elementarzelle besteht aus einer Schicht eines ferroelektrischen Materials und zwei unterschiedlichen leitenden Platten. Die Platten und die Schicht sind in der folgenden Reihenfolge angeordnet: eine erste leitende Platte - ein ferroelektrisches Material - eine zweite leitende Platte, die sich von der ersten unterscheidet. Alle Platten und die Schicht im Paket sind eng aneinander angebracht. Die leitenden Platten bestehen aus unterschiedlichen Leitern mit unterschiedlicher Konzentration freier Elektronen. Ferroelektrische Halbleiter, die als ferroelektrisches Material verwendet werden, können aus der Liste von Natriumnitrit, Halbleiterkeramiken auf Basis von Bariumtitanat, Lithiumniobat, Kaliumniobat, Bleititanat usw. ausgewählt werden.

Durch RU 2419951 ist ein Stromumwandler umfassend ein Gehäuse mit einem Paket durch eine Schicht eines ferroelektrischen Materials getrennter leitender Platten aus unterschiedlichen Leitern mit unterschiedlicher Konzentration freier Elektronen bekannt. Die Platten beider Vorzeichen und die Schicht liegen eng aneinander an.

Durch HEYWANG "Semiconducting Barium Titanate" Journal of Materials Science 6, 1971 pp 1214-1226 ist bekannt, dass es sich bei Bariumtitanat um ein ferroelektrisches Mateiral mit extrem hoher Permittivität (Dielektrizitätskonstante) handelt.

Zur Herstellung von Halbleiterkeramiken auf Basis von Bariumtitanat wird es dotiert.

Durch RU 2162457, IPC (7) C04B35/468, C04B35/64, veröffentlicht am 27.01.2001) ist bekannt, das ferroelektrische Material Bariumtitanat BaTi0₃ bei dem es sich um ein Dielektrikum mit einem spezifischen elektrischen Widerstand von mehr als 1012 Ohm · cm handelt, durch so genannte Zwangsreduktion (RU 2162457, IPC (7) C04B35/468, C04B35/64, veröffentlicht am 27.01.2001) in einen ferroelektrischen Halbleiter mit einem spezifischen Widerstand von 10 Ohm · cm bis 103 Ohm · cm umzuwandeln.

Durch G. G. Emello, T. A. Shichkova "Das Sol-Gel-Verfahren zur Herstellung von Halbleiter-Bariumtitanat, dotiert mit Lanthanoxid Bal-XLaXTi03 und Wolframoxid BaTil-XWX03 (x = 0,001, 0,002)", Festkörperchemie und moderne Mikro- und Nanotechnologie VI Internationale Konferenz Kislovodsk Stavropol: NCSTU, 2006; S. 510, ist bekannt, das ferroelektrische Material Bariumtitanat BaTi0₃ durch Kontrolle seiner Wertigkeit in einen ferroelektrischen Halbleiter mit einem spezifischen Widerstand von 10 Ohm · cm bis 103 Ohm · cm umzuwandeln.

Eine Aufgabe der Erfindung ist ein Verfahren zur Herstellung eines auch als Umgebungsenergieelektrischer-Wandler bezeichneten Umgebungsenergiewandlers, auch Umgebungsenergie-Wandler, zu schaffen, bevorzugt eines umgebungsenergieelektrischen Elements, welches Elektrizität aus Umgebungsenergie schöpft und bereitstellt.

Die Aufgabe wird durch die Merkmale des unabhängigen Anspruchs gelöst. Vorteilhafte Ausführungsformen sind in den Ansprüchen, den Zeichnungen sowie in der nachfolgenden Beschreibung, einschließlich der zu den Zeichnungen zugehörigen, wiedergegeben.

Wichtig ist hervorzuheben, dass die Erfindung verwirklicht sein kann durch ein Verfahren zur Herstellung eines Umgebungsenergiewandlers mit mindestens einer Elementarzelle. Der Umgebungsenergiewandler beziehungsweise dessen Elementarzelle umfasst ein plattenförmiges Trägersubstrat aus einem ersten Leitermaterial als erste Elektrode und einen auf dieser angeordneten Schichtaufbau mit einer Schicht ferroelektrischen Materials und einer Schicht eines von dem ersten Leitermaterial verschiedenen zweiten Leitermaterials als zweite Elektrode. Die beiden Leitermaterialien weisen unterschiedliche Konzentrationen freier Elektronen auf. Das ferroelektrische Material umfasst bevorzugt einen oder mehrere ferroelektrische Halbleiter. Ferroelektrische Halbleiter, die als ferroelektrisches Material verwendet werden, können aus der Liste von Natriumnitrit, Halbleiterkeramiken auf Basis von Bariumtitanat, Lithiumniobat, Kaliumniobat, Bleititanat usw. ausgewählt werden.

Das Verfahren sieht vor, zunächst eine Platte aus dem für die erste Elektrode vorgesehenen Leitermaterial als Trägersubstrat zur Verfügung zu stellen.

Anschließend wird das Trägersubstrat mindestens einer Oberflächenbehandlung unterzogen.

Danach wird eine Schicht ferroelektrischen Materials, kurz BTO, auf eine als Vorderseite vorgesehene Seite des Trägersubstrats aufgetragen. Diese Schicht kann auch als BTO-Schicht bezeichnet werden.

Wichtig ist hervorzuheben, dass die Kurzbezeichnung BTO stellvertretend für jegliches ferroelektrische Material - auch Materialkombinationen - stehen kann, besonders bevorzugt jedoch für einen ferroelektrischen Halbleiter, insbesondere für Bariumtitanat BaTiO₃ oder Kombinationen hiermit und/oder hieraus.

Schließlich wird eine Schicht aus dem für die zweite Elektrode vorgesehenen Leitermaterial maskiert innerhalb der BTO-Schicht auf die mit der BTO-Schicht versehene Vorderseite des Trägermaterials aufgetragen. Die Maskierung dient der Sicherstellung, dass es außerhalb der BTO-Schicht zu keinem Kontakt zwischen den Leitermaterialien der ersten und der zweiten Elektrode kommt. Innerhalb der mit der BTO-Schicht versehenen Partie der Vorderseite des Trägersubstrats sind die Leitermaterialien der ersten und der zweiten Elektrode durch die BTO-Schicht voneinander getrennt.

Das Verfahren kann einzelne oder eine Kombination der zuvor und/oder nachfolgend in Verbindung mit dem Umgebungsenergie-Wandler und/oder umgebungsenergieelektrischen Element und/oder umgebungsenergieelektrischen Umwandler beschriebene Merkmale aufweisen und/oder verwirklichen, ebenso wie der Umgebungsenergie-Wandler und/oder das umgebungsenergieelektrische Element und/oder der umgebungsenergieelektrische Umwandler einzelne oder eine Kombination mehrerer zuvor und/oder nachfolgend in Verbindung mit dem Verfahren beschriebene Merkmale aufweisen und/oder verwirklichen kann.

Das Verfahren und/oder der Umgebungsenergie-Wandler und/oder das umgebungsenergieelektrische Element und/oder der umgebungsenergieelektrische Umwandler können alternativ oder zusätzlich einzelne oder eine Kombination mehrerer einleitend in Verbindung mit dem Stand der Technik und/oder in einem oder mehreren der zum Stand der Technik erwähnten Dokumente und/oder in der nachfolgenden Beschreibung zu den in den Zeichnungen dargestellten Ausführungsbeispielen beschriebene Merkmale aufweisen.

Zusätzliche, über die vollständige Lösung der gestellten Aufgabe und/oder über die voran zu den einzelnen Merkmalen genannten Vorteile hinausgehende Vorteile gegenüber dem Stand der Technik sind nachfolgend aufgeführt.

Die Erfindung wird nachfolgend anhand von in der Zeichnung dargestellter Ausführungsbeispiele näher erläutert. Die Größenverhältnisse der einzelnen Elemente zueinander in den Figuren entsprechen nicht immer den realen Größenverhältnissen, da einige Formen vereinfacht und andere Formen zur besseren Veranschaulichung vergrößert im Verhältnis zu anderen Elementen dargestellt sind. Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figur erforderlich sind. Die dargestellten Ausführungsformen stellen lediglich Beispiele dar, wie die Erfindung ausgestaltet sein kann und stellen keine abschließende Begrenzung dar. Es zeigen in schematischer Darstellung:
- Fig. 1: eine Prinzipskizze einer einen in einem Gehäuse 1 beherbergten Umgebungsenergiewandler umfassenden Elementarzelle eines Elektrizität aus Umgebungsenergie erzeugenden Stromumwandlers.
- Fig. 2: ein Anordnungsbeispiel mehrerer in Serie geschalteter Elementarzellen.
- Fig. 3: ein Anordnungsbeispiel mehrerer parallel geschalteter Elementarzellen.
- Fig. 4: ein Anordnungsbeispiel mehrerer kombiniert (in Serie und parallel) geschalteter Elementarzellen.
- Fig. 5: eine schematische Darstellung eines Ablaufs eines Verfahrens zur Herstellung eines Umgebungsenergiewandlers.

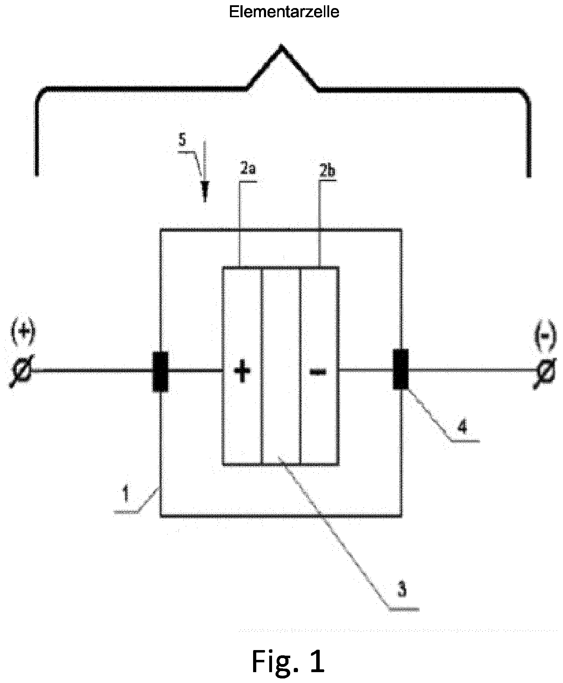

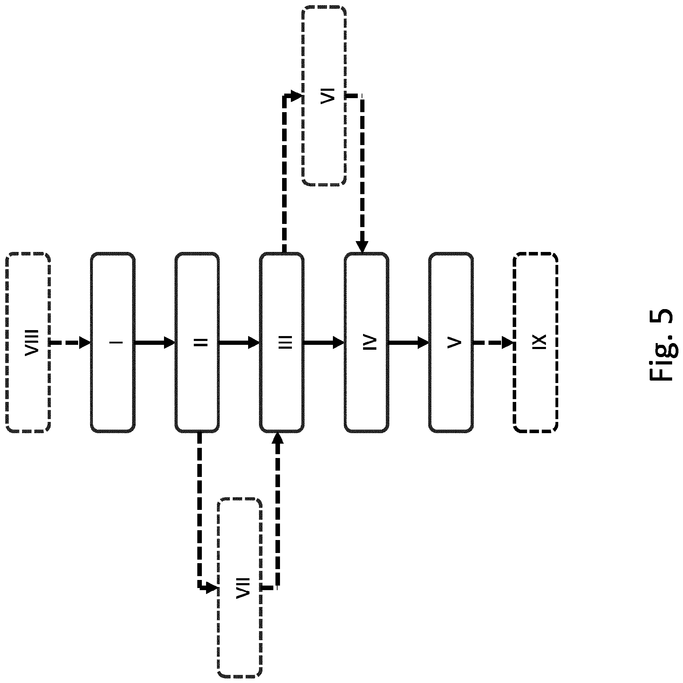

Ein in Fig. 5 in seinem Ablauf ganz oder in Teilen dargestelltes Verfahren dient der Herstellung eines Umgebungsenergiewandlers mit:
- einem plattenförmigen Trägersubstrat aus einem ersten Leitermaterial als erste Elektrode 2, 2a, 2b, und
- einem auf dieser angeordneten Schichtaufbau mit einer als BTO-Schicht 3 bezeichneten Schicht ferroelektrischen Materials und einer Schicht eines von dem ersten Leitermaterial verschiedenen zweiten Leitermaterials als zweite Elektrode 2, 2b, 2a (Bezugszeichen siehe Fig. 1, Fig. 2, Fig. 3, Fig. 4).

Die beiden Leitermaterialien weisen unterschiedliche Konzentrationen freier Elektronen auf. Das ferroelektrische Material umfasst bevorzugt einen oder mehrere ferroelektrische Halbleiter. Ferroelektrische Halbleiter, die als ferroelektrisches Material verwendet werden, sind vorteilhaft aus der Liste von Natriumnitrit, Halbleiterkeramiken auf Basis von Bariumtitanat, Lithiumniobat, Kaliumniobat, Bleititanat, etc. ausgewählt.

Das Verfahren sieht in einem ersten Verfahrensschritt I eine Bereitstellung einer Platte aus dem für die erste Elektrode vorgesehenen Leitermaterial als Trägersubstrat vor.

Ein auf den ersten Verfahrensschritt I folgender, zweiter Verfahrensschritt II sieht eine Unterziehung des Trägersubstrats mindestens einer Oberflächenbehandlung vor. Das Trägersubstrat wird beispielsweise zumindest auf seiner als Rückseite vorgesehene Seite einer Oberflächenbehandlung in Strahltechnik unterzogen. Bevorzugt wird Kugelstrahlen, besonders bevorzugt Glaskugelstrahlen als Oberflächenbehandlung zumindest der Rückseite des Trägersubstrats angewandt. Alternativ oder zusätzlich, bevorzugt im Anschluss an eine erste Oberflächenbehandlung in Strahltechnik wird das Trägersubstrat als beispielsweise zweite Oberflächenbehandlung entfettet. Vorteilhaft erfolgt das Entfetten unter Verwendung von H₂O₂.

Ein auf den zweiten Verfahrensschritt II folgender, dritter Verfahrensschritt III sieht ein Auftragen der kurz als BTO-Schicht bezeichneten Schicht ferroelektrischen Materials, bevorzugt eines ferroelektrischen Halbleiters, besonders bevorzugt Bariumtitanat BaTiO₃, kurz BTO, auf eine als Vorderseite vorgesehene Seite des Trägersubstrats vor.

In einem auf den dritten Verfahrensschritt III folgender, vierten Verfahrensschritt IV erfolgt eine Maskierung zumindest der Ränder der BTO-Schicht auf der Vorderseite des Trägersubstrats unter Freihaltung mindestens einer innerhalb der Ränder der BTO-Schicht befindlichen Partie.

Ein auf den vierten Verfahrensschritt IV folgender, fünfter Verfahrensschritt V sieht ein Auftragen des für die zweite Elektrode vorgesehenen Leitermaterials auf die von der Maskierung freigehaltene Partie vor.

Das Verfahren sieht hiernach vor, zunächst eine Platte aus dem für die erste Elektrode vorgesehenen Leitermaterial als Trägersubstrat zur Verfügung zu stellen.

Anschließend wird das Trägersubstrat mindestens einer Oberflächenbehandlung unterzogen.

Danach wird eine Schicht ferroelektrischen Materials, bevorzugt eines ferroelektrischen Halbleiters, besonders bevorzugt Bariumtitanat (BaTiO₃), kurz BTO, auf eine als Vorderseite vorgesehene Seite des Trägersubstrats aufgetragen. Diese Schicht wird auch BTO-Schicht bezeichnet.

Wichtig ist hervorzuheben, dass die Kurzbezeichnung BTO stellvertretend für jegliches ferroelektrische Material - auch Materialkombinationen - stehen kann, besonders bevorzugt jedoch für einen ferroelektrischen Halbleiter, insbesondere für Bariumtitanat BaTiO₃ oder Kombinationen hiermit und/oder hieraus.

Schließlich wird eine Schicht aus dem für die zweite Elektrode vorgesehenen Leitermaterial bevorzugt maskiert innerhalb der BTO-Schicht auf die mit der BTO-Schicht versehene Vorderseite des Trägermaterials aufgetragen. Die Maskierung dient der Sicherstellung, dass es außerhalb der BTO-Schicht zu keinem Kontakt zwischen den Leitermaterialien der ersten und der zweiten Elektrode kommt. Innerhalb der mit der BTO-Schicht versehenen Partie der Vorderseite des Trägersubstrats sind die Leitermaterialien der ersten und der zweiten Elektrode durch die BTO-Schicht voneinander getrennt.

Das Verfahren kann einen zwischen dem dritten Verfahrensschritt III und dem vierten Verfahrensschritt IV angeordneten zusätzlichen Verfahrensschritt VI vorsehen. In diesem wird nach dem Auftragen der Schicht ferroelektrischen Materials (BTO-Schicht) auf die als Vorderseite vorgesehene Seite des Trägersubstrats, und vor dem Auftragen des für die zweite Elektrode vorgesehenen Leitermaterials auf die von der Maskierung freigehaltene Partie eine Qualitätskontrolle der BTO-Schicht unter Überprüfung der BTO-Schicht zumindest innerhalb der von der Maskierung freigehaltenen Partie auf zumindest abschnittsweise Homogenität ihrer Schichtdicke und/oder zumindest abschnittsweise geschlossene Abdeckung des Trägersubstrats vorgenommen.

Dies dient der Sicherstellung, dass es beim anschließenden Auftragen des für die zweite Elektrode vorgesehenen Leitermaterials zu keinen Berührstellen zwischen den beiden Leitermaterialien kommt. Berührstellen zwischen den Leitermaterialien für die erste und für die zweite Elektrode sowohl innerhalb der BTO-Schicht, als auch seitlich um die BTO-Schicht herum führen zu einem Kurzschluss der beiden Elektroden und damit zum Ausschuss des bis dato hergestellten Teils des Umgebungsenergiewandlers.

Das Verfahren kann einen beispielsweise zwischen dem zweiten Verfahrensschritt II und dem dritten Verfahrensschritt III angeordneten zusätzlichen Verfahrensschritt VII vorsehen. Dieser sieht vor, dass vor dem Auftragen des für die zweite Elektrode vorgesehenen Leitermaterials auf die von der Maskierung freigehaltene Partie, besonders bevorzugt vor dem Maskieren, die BTO-Schicht dotiert wird.

Dieser zusätzliche Verfahrensschritt VII kann alternativ unabhängig vom dritten Verfahrensschritt III außerhalb der Reihe der bis dato erfolgten ersten und zweiten Verfahrensschritte I, II erfolgen. In einem solchen zusätzlichen Verfahrensschritt VII wird vor dem Auftragen der BTO-Schicht das für die BTO-Schicht vorgesehene ferroelektrische Materials dotiert.

Unabhängig davon, ob der zusätzliche Verfahrensschritt VII nach oder vor dem dritten Verfahrensschritt III ausgeführt wird, wird im zusätzlichen Verfahrensschritt VII vor dem Auftragen des für die zweite Elektrode vorgesehenen Leitermaterials ein Dotierprozess mit dem Ziel durchgeführt, eine mittlere Nb-Konzentration in der BTO-Schicht von 0,3at% zu erhalten. Eine Optimierung des Nb-Gehalts wird vorteilhaft mittels EDS-Messungen erhalten.

Das Auftragen des ferroelektrischen Materials zur BTO-Schicht im dritten Verfahrensschritt III und/oder das Auftragen des für die zweite Elektrode vorgesehenen Leitermaterials im fünften Verfahrensschritt V erfolgt vorteilhaft durch Gasphasenabscheidung.

Zur Gasphasenabscheidung sowohl wahlweise des ferroelektrischen Materials zur BTO-Schicht oder des für die zweite Elektrode vorgesehenen Leitermaterials, als auch des ferroelektrischen Materials zur BTO-Schicht und des für die zweite Elektrode vorgesehenen Leitermaterials, kommen CVD chemical vapour deposition; chemische Gasphasenabscheidung ebenso wie PVD (physical vapour deposition; physikalische Gasphasenabscheidung) in Frage.

Bevorzugt findet eine physikalische Gasphasenabscheidung (PVD) als Methode zur Gasphasenabscheidung im dritten Verfahrensschritt III und/oder im fünften Verfahrensschritt V statt.

Zu PVD als bevorzugte Methode zur Gasphasenabscheidung zählen insbesondere:
- kurz unter dem Begriff Vakuumbedampfen zusammengefasste Verdampfungsverfahren, wie etwa auch Bedampfen genanntes thermisches Verdampfen, Elektronenstrahlverdampfen (electron beam evaporation), Laserstrahlverdampfen (pulsed laser ablation; Atome und Ionen werden durch einen kurzen, intensiven Laserimpuls verdampft), Lichtbogenverdampfen (arc evaporation; Arc-PVD; Atome und Ionen werden durch einen starken Strom, der bei elektrischer Entladung wie bei einem Blitz zwischen zwei Elektroden fließt, aus dem Ausgangsmaterial herausgelöst und in die Gasphase überführt), Molekularstrahlepitaxie (molecular beam epitaxy).
- Kurz als Sputtern bezeichnete, auch als Kathodenzerstäubung bezeichnete Sputterdeposition, wobei das Ausgangsmaterial durch Ionenbeschuß zerstäubt und in die Gasphase überführt wird, als auch lonenstrahlgestützte Deposition (ion beam assisted deposition; IBAD), wobei ebenfalls ein Abscheiden bei gleichzeitiger Synthese von Metallatomen und Gasen auf Substraten erfolgt, zusätzlich jedoch die in die Gasphase überführten Gasmoleküle durch lonenquellen dissoziiert, ionisiert und gleichzeitig einer meist beheizten Substratoberfläche angeboten werden.
- lonenplattieren (ion plating), wobei eine höherwertige Metallschicht plasmagestützt auf ein anderes Metall aufgebracht wird. Dabei wird zunächst ein so genanntes soft etch per Sputtern durchgeführt, bei dem die Substratoberfläche mittels lonenbeschuss aus dem Plasma gereinigt wird. Anschließend wird aus einer Verdampferquelle Metalldampf zugeführt. Dieser ionisiert teilweise im Plasma und wird durch eine elektrische Vorspannung zwischen 0,3 bis 5 kV am bevorzugt vorgeheizten Substrat auf dessen Oberfläche beschleunigt und bildet auf dem Substrat eine Schicht des verdampften Materials. Durch den ständigen Beschuss mit Metallionen wird immer wieder ein Teil des Substrats bzw. der Schicht abgetragen, i.e. abgesputtert. Die gelösten Atome kondensieren wieder auf dem Substrat und tragen zur Schichtbildung bei. Der ständige lonenbeschuss modifiziert die Schichteigenschaften. Unter Anderem kann er die Haftung der Schicht verbessern. Die entstehende Schichtstruktur ist abhängig von der Temperatur des Substrats. Vorzugsweise erfolgt das lonenplattieren unter einem Arbeitsdruck zwischen 2 Pa und 8 Pa, besonders bevorzugt von 5 Pa.
- Reaktives lonenplattieren (RIP). Dabei wird zusätzlich ein reaktives Gas in das Plasma eingebracht, das ebenfalls ionisiert, mit dem zerstäubten Metall reagiert und eine Schicht aus der entstehenden Verbindung bildet. Auf diese Weise lässt sich eine Titannitrid-Schicht aus Titan-Dampf und eingeleitetem Stickstoff erzeugen.
- ICB-Technik (ionized cluster beam), auch ICBD (ionized cluster beam deposition), wobei es sich um ein modifiziertes Aufdampfverfahren zur Herstellung dünner Schichten Metalle, Dielektrika und Halbleiter bei niedrigen Substrattemperaturen. Der verwendete Tiegel mit dem geschmolzenen Ausgangsmaterial wird zunächst geschlossen gehalten. Durch Verdampfen des Materials und Aufheizen des Materialdampfs entsteht im abgeschlossenen Tiegel ein Überdruck. Beim Erreichen eines prozessspezifischen Drucks wird der Dampf für die Beschichtung unter adiabatischer Expansion durch eine Düse abgelassen. Dabei kommt es zu einer Art Kondensation im Gasraum, bei dem sich elektrisch neutrale Atomhaufen, sogenannte cluster, bestehend aus ca. 500 bis 2000 Atomen, bilden. Diese neutralen Atomhaufen werden im Gasraum durch Stöße mit einem Elektronenstrahl teilweise ionisiert, vorzugsweise zu etwa 5% bis 35%. Anschließend werden sie in einem elektrischen Feld zur Substratoberfläche hin beschleunigt. Beim Auftreffen auf der Substratoberfläche zerfallen diese Atomhaufen teilweise, verteilen sich dabei auf der Oberfläche und bilden eine kondensierte Schicht. Über die Beschleunigungsspannung des elektrischen Felds ist es möglich die durchschnittliche Energie der Atomhaufen von der rein thermischen Energie auf über 200 eV pro Atom zu variieren. Dies ermöglicht eine kontrollierte Abscheidung von kristallinen Schichten und Epitaxie. Die Beschichtungseigenschaften (Schichtkonformität usw.) des Verfahrens wird hauptsächlich durch die charakteristische Struktur sowie die Wirkung der Ionisierung und Beschleunigung der Atomhaufen beeinflusst. Die Beschleunigungsspannung kann aber auch dazu genutzt werden, die Energie der Cluster so einzustellen, dass ähnlich dem Sputtern ein Reinigungsoder gar Zerstäubungseffekt des Substrates erreicht wird.

Das Verfahren sieht bevorzugt vor, dass Nickel (Ni), Silber (AG), Messing, Aluminium (Al), legiertes Eisen (Fe), insbesondere Stahl, als Leitermaterial Anwendung finden, wobei Leitermaterialien mit unterschiedlichen Konzentrationen freier Elektronen für die erste und für die zweite Elektrode Anwendung finden, bevorzugt unterschiedliche Leitermaterialien.

Wichtig ist hervorzuheben, dass als Material für die Anode (+) und Kathode (-)alle Materialien verwendet werden können, die die Fähigkeit haben, elektrischen Strom zu leiten.

Das Verfahren sieht besonders vorteilhaft vor, dass zumindest Teile des Verfahrensablaufs unter Vakuumbedingungen, besonders vorteilhaft unter Hochvakuumbedingungen stattfinden.

Besonders bevorzugt finden zumindest Teile des Verfahrens unter Vakuum statt, vorzugsweise unter einem Gasdruck, der niedriger ist, als der kurz als Umgebungsdruck bezeichnete Luftdruck in der Umgebung.

Das Verfahren sieht vorteilhaft vor, dass zumindest Teile des Verfahrensablaufs unter einer Inertgasatmosphäre, besonders bevorzugt unter einer Edelgasatmosphäre stattfinden.

Eine bevorzugte Ausgestaltung des Verfahrens sieht vor, dass das Trägersubstrat in einem dem ersten Verfahrensschritt I vorangehenden zusätzlichen Verfahrensschritt VIII allein oder gemeinsam mit beispielsweise anderen Trägersubstraten auf einer auch als Carrier bezeichneten Vorrichtung angeordnet wird, um die in den verschiedenen Verfahrensschritten vorgesehenen Behandlungsschritte zu durchlaufen beziehungsweise nacheinander auszuführen.

Wichtig ist hervorzuheben, dass der Umgebungsenergiewandler beziehungsweise das umgebungsenergieelektrische Element aufgrund eines Energiezuflusses aus der Umgebung funktioniert.

Der Umgebungsenergiewandler beziehungsweise das umgebungsenergieelektrische Element wandelt Umgebungsenergie, wie beispielsweise Gravitationsenergie, kosmische Strahlung, elektrische Felder, Magnetfelder in der Umgebung, beispielsweise in Form von elektromagnetischen Wellen unterschiedlicher Frequenzen, von extrem niedrigen mechanischen Schwingungen, Schall, Radiowellen, Lichtstrahlung, - von Infrarot bis Ultraviolett, sowie dem gesamten Bereich der Röntgenstrahlung, in Elektrizität um.

Der Umgebungsenergiewandler beziehungsweise das umgebungsenergieelektrische Element arbeiten unter strikter Beachtung des Energieerhaltungssatzes, der Aufladung durch elektromagnetische Schwingungen und Weitbereichsimpulse. Sie wandeln eine breite Palette von potenzialarmen Umweltenergien in elektrische Energie um.

Das Verfahren erlaubt die Herstellung eines Umgebungsenergiewandlers beziehungsweise eines umgebungsenergieelektrischen Elements, welche beispielsweise in einem Stromumwandler Anwendung finden können.

Ein solcher Stromumwandler kann auch als Stromquelle in jedem Gerät verwendet werden, das elektrische Energie benötigt.

Dabei kann es sich um mobile Geräte, Haushaltsgeräte, Sonnenkollektoren, Elektrofahrzeuge, autonome Stromversorgungssysteme für Räumlichkeiten sowie für den Einsatz in der Militärindustrie handeln.

Diese Geräte können unabhängig von der Energie ihrer Umgebung aufgeladen werden und arbeiten autonom, ohne weiteres externes Aufladen. Wenn nötig, kann

Ein solches Gerät je nach programmierter Leistungscharakteristik auch an andere Stromquellen angeschlossen werden.

Die Geräte können an Orten weit weg von der Zivilisation eingesetzt werden.

Beispielsweise können solche Geräte im Weltraum, am Boden und unter der Erde, auf dem Wasser und unter dem Wasser, im menschlichen Körper eingesetzt werden, um nur einige denkbare Anwendungsgebiete zu nennen.

Der Hauptvorteil des Stromumwandlers ist die Fähigkeit, fernab der Zivilisation autonom zu arbeiten, weil er durch die Energie der Umgebung aufgeladen wird. Mit anderen Worten schöpft er die von ihm bereitgestellte elektrische Energie aus der Energie der Umgebung.

Dieses Funktionsprinzip verstößt nicht gegen den zweiten Hauptsatz der Thermodynamik und ihre Prinzipien. Alle Sonnenkollektoren funktionieren also nach dem gleichen Prinzip. Der einzige Unterschied ist die begrenzten Möglichkeiten, mit der Energie der Umgebung aufzuladen.

Zum Beispiel funktionieren Sonnenkollektoren im Winter schlechter. Der Umgebungsenergiewandler und ein mindestens einen solchen umfassender Stromumwandler kann in Temperaturbereichen von - 270 bis + 800 betrieben werden.

Der Umgebungsenergiewandler und ein mindestens einen solchen umfassender Stromumwandler arbeiten nach dem Gesetz der Energieerhaltung.

Nämlich: - nach dem Gesetz - Lavoisier, das Gesetz - Lavoisier - Laplace, das Gesetz - Lavoisier - Laplace und Hess. Ein Gesetz, das aus den Grundgesetzen der Thermochemie entdeckt wurde.

Die ausgewählten Materialien und ihre untersuchten Fähigkeiten und ihre Beschaffenheit ermöglichen es, in reiner Form oder in gemischter Form die gewünschten Eigenschaften gemäß der Leistungsbeschreibung zu erreichen.

Eine der Möglichkeiten von Materialien zur Stromerzeugung ist die Fähigkeit, die Energie der Umgebung in sich aufzunehmen und aufgeladen zu werden.

Ein breiter Bereich der absorbierten Energie - erzeugt eine Potentialdifferenz. Dies setzt wiederum diese Materialien in Bewegung. Während des Betriebs sorgt die Energie der Umgebung aufgrund des Potentialunterschieds der Energie in der Umgebung dafür, dass der Umgebungsenergiewandler funktioniert und Energie in Gleichstrom umgewandelt wird.

Ein solcher, den Umgebungsenergiewandler beziehungsweise das umgebungsenergieelektrische Element umfassender Stromumwandler besteht beispielsweise aus einem Gehäuse 1, welches den Umgebungsenergiewandler beziehungsweise das umgebungsenergieelektrische Element beherbergt.

Das Verfahren kann zur Herstellung eines umgebungsenergieelektrischen Umwandlers mindestens einen dem fünften Verfahrensschritt V nachgeordneten zusätzlichen Verfahrensschritt IX aufweisen.

In diesem zusätzlichen Verfahrensschritt IX kann der bis dato hergestellte Umgebungsenergiewandler beziehungsweise das bis dato hergestellte umgebungsenergieelektrische Element in ein Gehäuse 1 eingesetzt werden. Hierdurch wird eine Elementarzelle eines umgebungsenergieelektrischen Umwandlers erhalten.

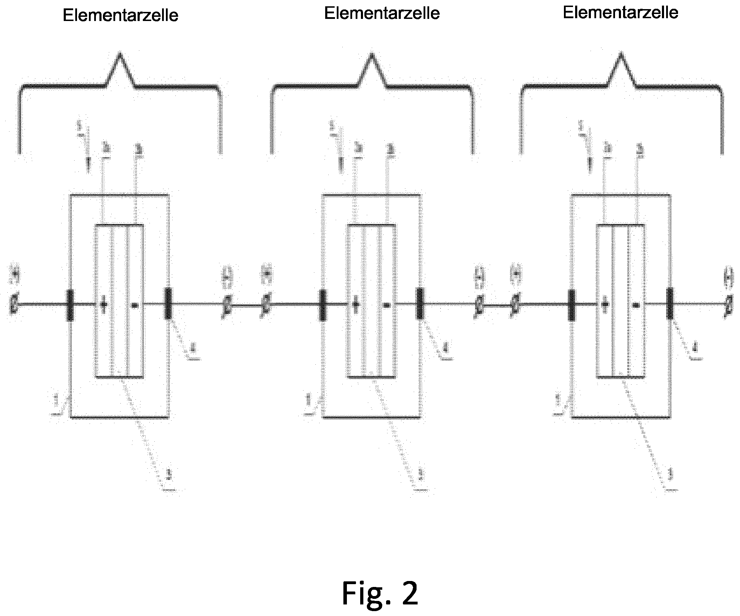

Das Verfahren erlaubt somit die Herstellung eines in Fig. 2, Fig. 3, Fig. 4, Fig. 5 ganz oder in Teilen dargestellten umgebungsenergieelektrischen Umwandlers - kurz Stromumwandlers - mit einem Gehäuse 1 und dem darin beherbergten Umgebungsenergiewandler mit dem Trägersubstrat aus dem ersten Leitermaterial als die erste Elektrode und dem darauf hergestellten Schichtaufbau aus BTO-Schicht und dem zweiten Leitermaterial für die zweite Elektrode als ein Paket aus leitenden Platten beider Merkmale, die aus einer Schicht eines ferroelektrischen Materials 3 und zwei unterschiedlichen leitenden Platten besteht, die in der folgenden Reihenfolge angeordnet sind: eine leitende Platte 2 - ein ferroelektrisches Material 3 - eine leitende Platte 2, die sich von der ersten unterscheidet.

Alle Schichten sind fest miteinander verbunden und eng aneinander angebracht und die als leitende Platten 2 bezeichneten ersten und zweiten Elektroden bestehen aus unterschiedlichen Leitern mit unterschiedlicher Konzentration freier Elektronen. Ferroelektrische Halbleiter, die als ferroelektrisches Material für die BTO-Schicht verwendet werden, können aus der Liste von Natriumnitrit, Halbleiterkeramiken auf Basis von Bariumtitanit, Lithiumniobat, Kaliumniobat, Bleititanit usw. ausgewählt werden.

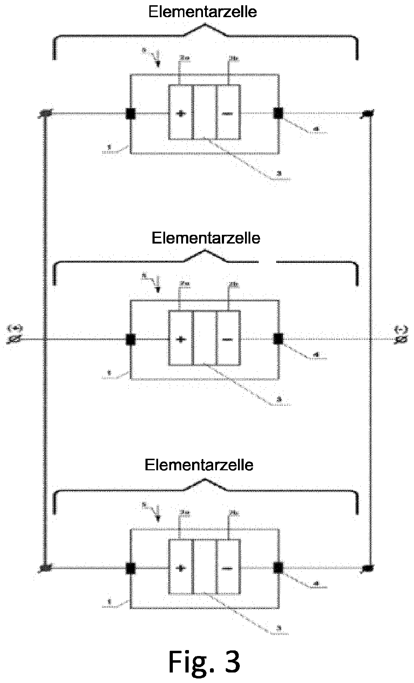

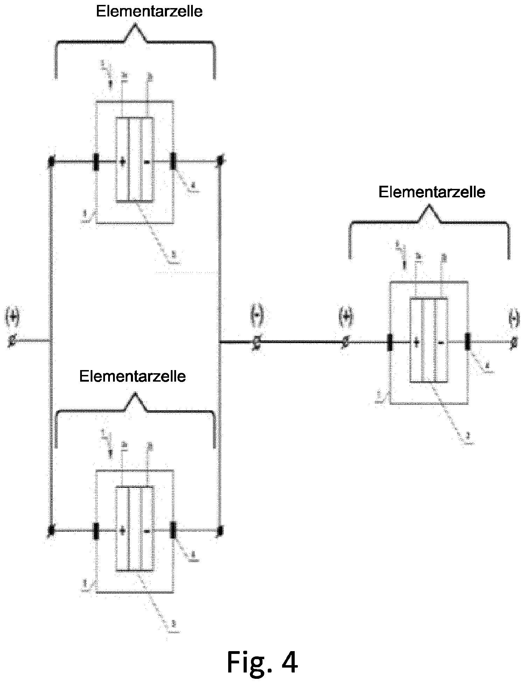

Der Stromumwandler umfasst demnach den in einem Gehäuse beherbergten Umgebungsenergiewandler als eine Elementarzelle. Der Stromumwandler kann mehrere Elementarzellen aufweisen. Diese können elektrisch in Serie (Fig. 2), parallel (Fig. 3), oder kombiniert (Fig. 4) angeordnet sein.

Wichtig ist hervorzuheben, dass folgende Verfahrensschritte ausgeführt werden können:
- Bereitstellung von Nickel- (Ni) Blechen als die erste Elektrode eines jeden Umgebungsenergieelektrischen-Wandlers beziehungsweise umgebungsenergieelektrischen Elements bildende Trägersubstrate, beispielsweise in einer Abmessung von 100x100mm. Dabei genügt eine technische Qualität, ohne besondere Anforderungen an Zusammensetzung und Verunreinigungen. Die Oberflächenrauigkeit ist vorteilhaft möglichst gering.
- Glaskugelstrahlen der Trägersubstratrückseite zur Verbesserung der Temperatureinkopplung.
- Entfetten des Trägersubstrats mit H₂O₂.
- Konstruktion und Fertigung eines Spezial-Carriers zum automatisierten Umgang mit den der Trägersubstraten beispielsweise mit einem Roboterarm einer VakuumBeschichtungsanlage.
- Konstruktion und Fertigung von zwei Keramik-Masken zur maskierten Ag- und Al- Abscheidung. Bei Trägersubstraten in Abmessungen von 100x100mm misst der Masken-Ausschnitt beispielsweise 90x90mm. Vorteilhaft kann eine Maske für die Herstellung einer als vollflächige Deckelektrode bezeichneten zweiten Elektrode, und eine Maske mit einer Gitterstruktur zur Abscheidung einer als Einzelelektroden-Array Deckelektrode bezeichneten zweiten Elektrode bereitgestellt werden.
- Bereitstellung eines Bariumtitanat (BaTiO₃), kurz BTO-Targets zur PVD Beschichtung des Trägersubstrats mit der BTO-Schicht in einer ersten Vakuumkammer.
- Bereitstellung eines Niob- (Nb) Targets zur Nb-Dotierung zumindest der BTO-Schicht.
- Montage Nb-Target, Prozesseinrichtung Dotierprozess mit Ziel mittlere Nb-Konzentration in BTO-Schicht 0,3at% Optimierung Nb-Gehalt mittels EDS-Messungen.
- Bereitstellung und Montage eines Silber- (Ag) Targets als Leitermaterial für die zweiten Elektrode in einer zweiten Vakuumkammer. Prozessinbetriebnahme einschließlich Rate und Schichtdickenverteilung.
- Alternative Bereitstellung und Montage eines Aluminium- (Al) Targets als Leitermaterial für die zweiten Elektrode in einer zweiten Vakuumkammer. Prozessinbetriebnahme einschließlich Rate und Schichtdickenverteilung.

Erwartete Schicht- und Dotierhomogenitäten auf Durchmesser 100mm

| Schicht | Homogenität |
|---|---|
| BTO | ±30% |
| Nb-Dotierung | ±8% bezogen auf Absolut-Gehalt in BTO-Schicht |
| | ±38% bezogen auf relativen Gehalt in der BTO-Schicht |
| Ag-Deckbeschichtung | ±15% |
| Al-Deckbeschichtung | ±3% |

Parametervariationen der Trägersubstratbeschichtungen:

| Probe | Nb-Dotierung | BTO-Beschichtunq | Deckelektrode |
|---|---|---|---|
| a | Mit | Standard | AI Einzelelektroden-Array |
| b | Mit | Zwischenpolieren | AI vollflächig |
| c | Mit | Zwischenpolieren | Ag Einzelelektroden-Array |
| d | Ohne | Standard | AI Einzelelektroden-Array |
| e | Ohne | Zwischenpolieren | AI vollflächig |
| f | Ohne | Zwischenpolieren | Ag Einzelelektroden-Array |

Die BTO-Beschichtung erfolgt bevorzugt vollflächig. Die BTO-Schicht nimmt das Trägersubstrat vorteilhaft vollständig ein, zumindest jedoch die vom zweiten Leitermaterial für die zweite Elektrode beim Auftragen eingenommene Partie zuzüglich eines dieses umgebenden Rands.

Die AI oder Ag-Beschichtung erfolgt maskiert, um Kontakt zwischen der auch als Deckelektrode bezeichenbaren zweiten Elektrode und dem Trägersubstrat zu vermeiden.

Aufgrund der Flächigkeit der Al- oder Ag-Deckelektrode ist das Risiko eines Kurzschlusses zwischen dem beispielsweise als Ni-Substrat ausgeführten Trägersubstrat und der als Deckelektrode bezeichneten zweiten Elektrode aufgrund von Defekten im Trägersubstrat oder in der BTO-Schicht hoch. Vorteilhaft wird daher optional ein Mehrstufen-Prozess zur BTO-Abscheidung mit "Zwischenpolieren" zwischen den einzelnen Stufen der Abscheidung ausgeführt. Optional ist auch die Abscheidung eines Arrays von Einzelelektroden statt einer flächigen Deckelektrode möglich, um Einzelelektroden mit Kurzschluss nicht zu verwenden.

Zur Qualitätskontrolle können während des Verfahrensablaufs folgende Parameter erfasst werden:
- Schichtdickenverteilung BTO.
- Schichtdickenverteilung Al und Ag.
- dreimalige EDS-Messungen zur Optimierung Nb-Gehalt.
- radial verteilte EDS-Messung mit drei Messpunkten zur Bestimmung Verteilung des Nb-Gehalts über das Trägersubstrat bzw. dessen Vorderseite hinweg.
- XRD: zwei Proben BTO (mit und ohne Nb).
- SEM mit lonenpräparation: zwei Proben BTO (mit und ohne Nb).

Zur Qualitätskontrolle im Rahmen der Substratbeschichtungen kann:
- die Dicke der BTO-Schicht auf einem außerhalb des Probenbereiches angeordneten Si-Referenzsubstrat bestimmt werden.
- die Dicke des Ag- und/oder Al- Leitermaterials für die zweite Elektrode auf einem außerhalb des Probenbereiches angeordneten Si-Referenzsubstrat bestimmt werden.
- Der elektrische Widerstand zwischen dem Trägersubstrat und der auch als Deckelektrode bezeichneten zweiten Elektrode beispielsweise mittels Multimeter gemessen werden.

Ein Herstellungsablauf kann beispielsweise vorsehen:
- Bestellung/ Lieferung Nb-Target.
- Recherche/Bestellung/ Lieferung Ni-Trägersubstrate.
- Konstruktion/ Fertigung angepasster Carrier.
- Abstimmung Design / Bestellung / Fertigung Schattenmasken.
- Substratreinigung.
- Vorbereitung BTO-Prozess.
- Testbeschichtungen.
- BTO-Beschichtung Trägersubstrate.
- Al-Metallisierung erste Charge Trägersubstrate.
- Inbetriebnahme co-Sputter-Prozess mit Nb.
- Zusammensetzungs-Optimierung.
- Nb:BTO Nb:BTO-Beschichtung Kundensubstrate.
- Al-Metallisierung zweite Charge Kundensubstrate.
- Ag-Metallisierung Kundensubstrate.

Das Verfahren erlaubt die Herstellung eines Elektrizität aus Umgebungsenergie schöpfenden Stromumwandlers.

Der elektrische Stromumwandler besteht aus einem Gehäuse 1, welches einen verfahrensgemäß hergestellten Umgebungsenergiewandler beherbergt.

Der Umgebungsenergiewandler kann beschrieben werden als ein Paket von Leitungsplatten beider Polaritäten als Elektroden, die durch eine Schicht aus stabilisiertem Einkristall-Ferroelektrikum getrennt sind. Alle Schichten in dem Paket liegen eng aneinander an. Das im Gehäuse 1 untergebrachte Plattenpaket bildet eine Elementarzelle 5. Das Plattenpaket ist Schicht für Schicht aus einem ferroelektrischen Material hergestellt., Es umfasst zwei Metallplatten aus ungleichem Leitermaterial mit einem erheblichen Unterschied in der Konzentration freier Elektronen. Verfahrensgemäß wird das Plattenpaket als ein Schichtaufbau auf einem Trägersubstrat aus einem ersten Leitermaterial als erste Elektrode 2, 2a, 2b aufgebaut. Die das Trägersubstrat umfassenden Schichten sind in der folgenden Reihenfolge angeordnet: eine leitende Platte aus einem ersten Leitermaterial als die erste Elektrode bildendes Trägersubstrat - eine BTO-Schicht ferroelektrischen Materials - eine als zweite Elektrode dienende Schicht aus von dem ersten Leitermaterial verschiedenem Leitermaterial. Die Elementarzellen 5 können zu einer elektrischen Energiequelle in Serie (Fig. 2) oder parallel (Fig. 3) oder in Kombination (Fig. 4) verbunden sein. Bei einer kombinierten Anordnung sind einige Elementarzellen 5 in Reihe geschaltet und einige sind parallel geschaltet. In der BTO-Schicht 3 sind stabilisierte Einkristalle aus ferroelektrischen Materialien durch stabilisierte Einkristalle aus ferroelektrischen Halbleitern, wie Natriumnitrit, Halbleiterkeramiken auf Basis von Bariumtitanat, Lithiumniobat, Kaliumniobat, Bleititanat usw. ersetzt. Dies verringert den elektrischen Innenwiderstand des Umgebungsenergiewandlers und damit der Elementarzelle 5. Außerdem erhöht dies die spezifische elektrische Leistung des Umgebungsenergiewandlers und damit der Elementarzelle 5, wenn sie an einen elektrischen Verbraucher angeschlossen wird.

Eine Besonderheit des Umgebungsenergiewandlers und damit der Elementarzelle 5 ist der Ersatz von stabilisierten Einkristallen aus ferroelektrischen Materialien durch stabilisierte Einkristalle aus ferroelektrischen Halbleitern, wie Natriumnitrit, Halbleiterkeramiken auf Basis von Bariumtitanat, Lithiumniobat, Kaliumniobat, Bleititanat etc..

Es ist bekannt, dass es ferroelektrische Materialien gibt, die auch Halbleitereigenschaften besitzen, die sogenannten Ferroelektrika - Halbleiter, die nach dem Wert des spezifischen elektrischen Widerstands (10-2 - 107 Ohm · cm) eine Zwischenstellung zwischen Leitern und Isolatoren einnehmen. Zum Beispiel Natriumnitrit (NaN02), Halbleiterkeramikmaterialien auf Basis von Lithiumniobat, Kaliumniobat, Bleititanat, Bariumtitanat und viele andere (siehe V.M. Fridkin Ferroelectric Semiconductors. -M.: Nauka, 1976. - 408 p. V. V. Ivanov, A. A. Bogomolov, Ferroelectric Semiconductors, Kalinin, Kalinin University Press, 1978, 96 S.)

Insbesondere das ferroelektrische Material Bariumtitanat BaTi0₃ ist ein Dielektrikum mit einem spezifischen elektrischen Widerstand von mehr als 1012 Ohm · cm. Es ist jedoch möglich, es in einen ferroelektrischen Halbleiter mit einem spezifischen Widerstand von 10-103 Ohm · cm umzuwandeln, beispielsweise durch erzwungene Erholung (siehe Patent RU 2162457, IPC (7) C04B35/468, C04B35/64, veröffentlicht am 27.01.2001) oder durch Kontrolle seiner Wertigkeit (siehe Festkörperchemie und moderne Mikro- und Nanotechnologie VI Internationale Konferenz Kislovodsk Stavropol: NCSTU, 2006. 510 S. Das Sol-Gel-Verfahren zur Herstellung von Halbleiter-Bariumtitanat, dotiert mit Lanthanoxid Bal-XLaXTi03 und Wolframoxid BaTil-XWX03 (x = 0,001, 0,002), G. G. Emello, T. A. Shichkova).

Zur Herstellung von Halbleiterkeramiken auf Basis von Bariumtitanat wird BaTi0₃ dotiert.

Titan-Ionen Ti⁴⁺ sind hierzu durch W⁶⁺ Sb⁵⁺, Nb⁵⁺, Ta⁵⁺, etc. Ionen ersetzt. Barium-Ionen Ba²⁺ sind hierzu durch Mn⁴⁺, La³⁺, Nd³⁺, Y³⁺, Gd³⁺ Ionen und andere ersetzt.

Die Konzentration der Dotierungselemente beträgt typischerweise weniger als 0,3 Atomprozent.

Der kausale Zusammenhang ist wie folgt:
- Die Verwendung von ferroelektrischen Halbleitern mit einem elektrischen Widerstand von weniger als 107 Ohm · cm als aktives Elementarzellenelement anstelle von ferroelektrischen Materialien, die ausgeprägte Dielektrika mit einem spezifischen elektrischen Widerstand von bis zu 1016 Ohm · cm sind, ermöglicht es, den inneren elektrischen Widerstand der Elementarzelle zu verringern und größere spezifische elektrische Ströme an den gleichen Paaren der Stromkollektoren der Elementarzelle zu erhalten.
- Die Erhöhung der spezifischen elektrischen Ströme bei konstanter Potentialdifferenz führt zu einem natürlichen Anstieg der spezifischen elektrischen Leistung einer Elementarzelle um mehr als das Zweifache im Vergleich zu einem Bariumtitanat-Prototyp.
- Die Erhöhung der spezifischen elektrischen Leistung einer Elementarzelle ermöglicht es, die Möglichkeiten der praktischen Nutzung des Stromumwandlers sowohl technisch als auch wirtschaftlich zu erweitern.

Der aus mindestens einer Elementarzelle bestehende Umwandler für elektrische Energie ist in Fig. 1 gezeigt. Dieser Umwandler besteht aus einem Gehäuse 1, in dessen Innerem zwei auch als Leiterpaar bezeichnete Elektroden 2, 2a, 2b angeordnet sind, die aus unterschiedlichen Leitermaterialien mit unterschiedlichen Konzentrationen an freien Elektronen bestehen. Zwischen den Elektroden 2, 2a, 2b befindet sich ein ferroelektrischer Halbleiter 3. Isolatoren 4 dienen der Durchführung mit den Elektroden 2, 2a, 2b verbundener elektrischer Kontakte durch das Gehäuse 1. Die elektrischen Kontakte dienen sowohl der Verschaltung mehrerer Elementarzellen untereinander (Fig. 2, Fig. 3, Fig. 4), als auch dem Anschluss elektrischer Verbraucher.

Als Beispiele für ferroelektrische Halbleiter, die zur Herstellung der Elemente des elektrischen Stromumwandlers verwendet werden, werden die folgenden Halbleiterkeramiken auf der Basis von Bariumtitanat angegeben:
- Bariumtitanat, dotiert mit Niob (Nb) mit einer Atomkonzentration von 0,220 % und spezifischer Widerstand von 6470 Ohm · cm;
- Bariumtitanat, dotiert mit Lanthan (La) mit einer Konzentration von 0,125 Atom-% und einem spezifischen Widerstand von 883.500 Ohm · cm.

Referenzmuster von Bariumtitanat-Prototypen werden unter Verwendung von Bariumtitanat mit einem spezifischen Widerstand von 2710000000 Ohm · cm hergestellt.

Eisen-Nickel wird als Paar ungleicher Leiter verwendet. Der Stromumwandler besteht aus mindestens einer Elementarzelle 5. Die Elementarzelle 5 wird durch sukzessive Vakuumabscheidung auf der antiadhäsiven Basisschicht mit einer Oberfläche von 1 dm² hergestellt.

Der Schichtaufbau auf dem als erste Elektrode 2, 2a, 2b dienenden, aus dem ersten Leitermaterial bestehenden Trägersubstrat hat vorteilhaft folgende Schichtdicken: Die als zweite Elektrode 2, 2b, 2a vorgesehene Schicht aus dem zweiten Leitermaterial wird vorteilhaft mit einer Dicke von 9-10 Mikron gebildet. Eine BTO-Schicht aus einem ferroelektrischen Halbleiter wird mit einer Dicke von weniger als 1 Mikron gebildet, wodurch eine kontinuierliche, porenfreie, gleichmäßige Beschichtung bereitgestellt wird.

### Beispiel 1.

Herstellung der Elementarzellen-Referenzprobe als Bariumtitanat-Prototyp. Eine Maske mit einer Oberfläche von 1 dm² wird auf die polierte Polytetrafluorethylen-Basisbeschichtung aufgebracht, die mit Polymethyl behandelt wurde, und eine Eisenschicht mit einer Dicke von 9-10 Mikron wird aufgesprüht. Die Maske wird entfernt und eine weitere Schicht aus Bariumtitanat wird aufgesprüht, wodurch eine durchgehende, gleichmäßige, porenfreie Beschichtung mit einer Dicke von bis zu 1 Mikrometer entsteht.

Dann wird die Maske zurückgelegt und eine Nickelschicht mit einer Dicke von 9-10 Mikron aufgesprüht. Die Maske wird entfernt und ein Finishelement wird mit einem Vakuumsauger von der Grundbeschichtung getrennt. Unter Verwendung von Diethylether werden Polymethylsiloxanspuren von der Oberflächenschicht aus Eisen entfernt und der Rest an Diethylether wird durch Abblasen trockener Luft entfernt. Dann wird die Elementarzelle zwischen Polklemmen aus Eisen bzw. Nickel platziert. Der erhaltene elektrische Stromumwandler wird mit einer Stromquelle verbunden.

### Beispiel 2.

Herstellung einer Elementarzelle aus mit Niob dotiertem Bariumtitanat.

Die Elementarzelle wird mittels der in Beispiel 1 beschriebenen Technik hergestellt, wobei anstelle von Bariumtitanat mit Niob dotiertes Bariumtitanat verwendet wird.

### Beispiel 3.

Die Elementarzelle wird mittels der in Beispiel 1 beschriebenen Technik hergestellt, wobei anstelle von Bariumtitanat mit Lanthan dotiertes Bariumtitanat verwendet wird.

Tabelle 1 zeigt die Beziehung zwischen der elektrischen Leistung (mW) und den Werten der Spannung (V) und des elektrischen Stroms (mA) einer Elementarzelle bei einer externen Last von 1000 Ohm aus ferroelektrischen Halbleitermaterialien relativ zu einer Referenzprobe des Bariumtitanat-Prototyps.

Die Arbeitsdauer jedes ferroelektrischen Halbleiters, der Teil einer einzelnen Elementarzelle ist wurde untersucht. Im Temperaturbereich von -20 bis +1 10 Grad Celsius wird jede Elementarzelle mehr als 18000 Stunden im Dauerbetrieb betrieben.

**Tabelle 1**

| ferroelektrisches Material | elektrische Leistung (mW) | Spannung (V) | Stromstärke (mA) |
|---|---|---|---|
| Bariumtitanat | 1.129 | 1.062 | 1.063 |
| Bariumtitanat dotiert mit Niob (Nb) | 2.358 | 1.060 | 2.225 |
| Bariumtitanat dotiert mit Lanthan (La) | 2.111 | 1.061 | 1.990 |

Wie aus Tabelle 1 ersichtlich ist, steigt die elektrische Leistung bei Verwendung von ferroelektrischen Halbleitern dramatisch an. Bei Verwendung von mit Niob (Nb) dotiertem Bariumtitanat erhöht sich die elektrische Leistung der Umwandler-Elementarzelle gegenüber dem Bariumtitanat-Prototyp um das 2.088-fache. Wenn mit Lanthan (La) dotiertes Bariumtitanat verwendet wird, erhöht sich die elektrische Leistung der Umwandler-Elementarzelle gegenüber dem Bariumtitanat-Prototyp um das 1869-fache. Der Stromumwandler hat gemäß seiner praktischen Anwendung einen erheblichen Vorteil gegenüber dem Bariumtitanat-Prototyp.

Nachfolgend sind Beispiele für Variationen des Herstellungsverfahrens und des durch dieses herstellbaren Umgebungsenergiewandlers angegeben.

Eine besonders bevorzugte Materialkombination für den Umgebungsenergiewandler ist Silber (Ag) - BaTiO₃ - Aluminium (Al).

Alternative Materialkombinationen sind
- Silber - BaTiO3 - Messing.
- Messing - BaTiO3 - Silber.
- Nickel - BaTiO3 - Aluminium.
- Aluminium - BaTiO3 - Nickel.
- Fe, (legiert) - BaTiO3 - Messing.
- Fe, (legiert) - BaTiO3 - Aluminium.
- Fe, (legiert) - BaTiO3 - Nickel.

Wichtig ist an dieser Stelle hervorzuheben, dass auch andere Optionen möglich sind.

Bei der Verwendung von Eisen als ein Leitermaterial wird dies bevorzugt als Trägersubstrat eingesetzt.

Grundsätzlich können für die beiden Elektroden beliebige leitfähige Materialien als Anode und Kathode verwendet werden.

Das erste Material - wird immer als Trägersubstrat verwendet.

Das erste Material, - das als Trägersubstrat verwendet wird, muss entfettet werden, beispielsweise mit Wasserstoffperoxid (H₂O₂).

Eine bevorzugte Ausgestaltung des Verfahrens zur Herstellung eines Umgebungsenergiewandlers unter Verwendung der besonders bevorzugten Materialkombination Silber (Ag) - BaTiO₃ - Aluminium (Al) sieht folgendes vor:

Für das als erste Elektrode 2, 2a, 2b dienende Trägersubstrat wird eine 1 mm dicke Silberplatte in den Abmessungen 10 cm x 10 cm (100 mm x 100 mm) verwendet.

Die Dicken können gemäß den eingestellten technischen Spezifikationen angepasst werden.

Als BTO-Schicht wird BaTiO₃ in einer Schichtdicke von 1 Mikrometer bis 10 Mikrometer oder mehr durch Sputterdeposition (Sputtern) auf die Silberplatte abgeschieden.

Die Dicken können gemäß den eingestellten technischen Spezifikationen angepasst werden.

Die als zweite Elektrode 2, 2b, 2a dienende dritte Materialschicht aus Aluminium als einem von dem Leitermaterial des Trägersubstrats verschiedenen Leitermaterial kann ebenfalls durch Sputterdeposition (Sputtern) in einer Dicke von 1 Mikron bis 10 Mikron oder mehr auf die BTO-Schicht aufgetragen werden.

Die Dicken der Schichten, insbesondere der BTO-Schicht und der die zweite Elektrode 2, 2b, 2a bildenden Schicht, einschließlich der Dicke des Trägersubstrats können gemäß den eingestellten technischen Spezifikationen angepasst werden.

Die Hauptforderung bei der Herstellung des Schichtaufbaus ist eine gleichmäßige Abdeckung, insbesondere der BTO-Schicht. Die BTO-Schicht ist zur Vermeidung eines unmittelbaren Kontakts zwischen den Leitermaterialien der ersten Elektrode 2, 2a, 2b und der zweiten Elektrode 2, 2b, 2a frei von Lücken, i.e. frei von Durchgangslöcher in der BTO-Schicht auszuführen. Dies kann gegebenenfalls durch einen der Qualitätskontrolle dienenden zusätzlichen Verfahrensschritt VI im Verfahrensablauf vorgesehen sein.

Zum Auftragen (Sputtern) des Schichtaufbaus, - kann mindestens eine Vakuum-Sprühkammer verwendet werden.

Vorteilhaft wird eine Hochvakuumkammer mit möglichst geringem Gasdruck im Arbeitsraum verwendet.

Mit einer Hochvakuumbeschichtung wird eine kontinuierliche gleichmäßige Beschichtung erzielt.

Die Beschichtung erfolgt vorteilhaft unter Abwesenheit von Umgebungsluft. Es ist vorteilhaft, eine Edelgas- gegebenenfalls Inertgasatmosphäre vorzusehen, insbesondere Argon.

Das Bariumtitanat (BaTiO3) der BTO-Schicht ist kristallin ausgebildet.

Das gewünschte Ergebnis wird durch das Kristallgitter erzielt, das sich während des Auftragens bildet.

BaTiO₃ ist von Natur aus ein ferroelektrischer Halbleiter.

Bariumtitanat (BaTiO₃) wirkt auch nach dem Sputtern als ferroelektrischer Halbleiter.

Bariumtitanat (BaTiO₃) wird heute mit seinen universellen Eigenschaften in verschiedenen Bereichen eingesetzt, in der Elektronik und Mikroelektronik (Sensoren, Aktoren, Kondensatoren), Biomedizin (Implantate).

Eine der Eigenschaften von Bariumtitanat (BaTiO3) als so genannter synoelektrischer Halbleiter in einer Struktur, in der Metalle die Rolle von Anode und Kathode spielen, ist Energie mit niedrigem Potential aus der Umgebung zu absorbieren und in sich selbst zu speichern.

Zum Beispiel - in den Beispielen angegebene (BaTiO₃) und seine Eigenschaften, erlauben es, die Wirkung von Licht, sowie elektromagnetischen Wellen unterschiedlicher Frequenzen, von extrem niedrigen mechanischen Schwingungen, Schall, Funkwellen, bis hin zu Lichtstrahlung - aufzunehmen Infrarot bis Ultraviolett. Und auch die Eigenschaften von (BaTiO₃) als Material, die in Speichergeräten funktionieren, ermöglichen die Verwendung von (BaTiO₃) in der Elektronik und Mikroelektronik. Zum Beispiel in Kondensatoren sowie in dem verfahrensgemäß hergestellten Umgebungsenergiewandler.

Ferroelektrische Halbleiter als nanostrukturierte ferroelektrische Materialien können viele technische Probleme lösen, um die Größe von Geräten zu reduzieren.

Der verfahrensgemäß hergestellte Umgebungsenergiewandler und der diesen wie vorgeschlagen umfassende Stromumwandler unterscheidet sich von anderen alternativen Quellen zur Erzeugung elektrischer Energie dadurch, dass er ferroelektrische Halbleiter verwendet, die es ermöglichen, den Umgebungsenergiewandler aus Umgebungsenergie mit niedrigem Potenzial aufzuladen.

Im Kern ist der Umgebungsenergiewandler teilweise ein Kondensator, das heißt, er hat die Fähigkeit, Energie zu akkumulieren und zu speichern.

Der Hauptunterschied besteht darin, dass der Kondensator aus dem Stromnetz aufgeladen wird, während der Umgebungsenergiewandler mit Energie mit niedrigem Potential, kosmischen Wellenstrahlen, elektrischen und magnetischen Feldern in der Umgebung aufgeladen wird.

Dieses Prinzip verstößt nicht gegen den Energieerhaltungssatz und den zweiten Hauptsatz der Thermodynamik.

Bariumtitanat (BaTiO₃) ist ein einzigartiges und vielseitiges Material, dessen Fähigkeiten bis heute noch nicht vollständig erforscht sind.

Beispielsweise weist Bariumtitanat (BaTiO₃) eine auch als Photorefractive-Effekt bezeichnete Photorefraktivität auf, die sich in einer lokalen Änderung des Brechungsindex in Abhängigkeit von der auf es einfallenden Lichtwelle bemerkbar macht.

Dadurch verändert der Lichtstrahl selbst die Bedingungen seiner Ausbreitung.

Diese Eigenschaft des auf sich selbstwirkenden Lichts kann verwendet werden, um optische Funktionen wie phasenkonjugierte Spiegel (die Licht in die Richtung zurückwerfen, aus der es gekommen ist), optische Computer, optische Schalter, dynamische Hologramme und insbesondere holografische Speichervorrichtungen auszuführen.

Im vorliegenden Fall ist der photorefraktive Effekt eine der Arten der Absorption und Erhaltung von Bariumtitanat, Energie mit niedrigem Potential aus der Umgebung aufzunehmen und in sich selbst zu speichern.

Das Verfahren kann alternativ oder zusätzlich einzelne oder eine Kombination mehrerer einleitend in Verbindung mit dem Stand der Technik und/oder in einem oder mehreren der zum Stand der Technik erwähnten Dokumente und/oder in der voranstehenden Beschreibung oder den nachfolgenden Ansprüchen erwähnte Merkmale aufweisen.

Die Erfindung kann durch oder in Zusammenhang mit einem voranstehend beschriebenen Umgebungsenergiewandler oder einem mindestens einen solchen umfassenden Stromumwandler verwirklicht sein.

Zusätzliche, über eine vollständige Lösung der der Erfindung zu Grunde liegenden Aufgabe sind eine Verwendung neuer Materialien, insbesondere ferroelektrische Halbleiter. Diese Materialien wurden bisher nicht zur Schöpfung und Bereitstellung von elektrischer Gleichstromenergie verwendet.

Diese Erfindung hat eine Reihe von Vorteilen gegenüber anderen Stromquellen, wie beispielsweise Umweltfreundlichkeit, Vielseitigkeit in der Anwendung und niedrige Produktionskosten.

Weitere Vorteile sind:
- Ähnliche Energiequellen gibt es heute nicht, die vorgeschlagenen UmgebungsenergieWandler, umgebungsenergieelektrischen Elemente und die hierauf aufbauenden Stromumwandlern, kurz Umgebungsenergiewandler, haben nichts mit galvanischen Batterien (Batterien, Akkumulatoren usw.) zu tun.
- Die Fähigkeit, sich selbst aufzuladen und Gleichstrom zu erzeugen ermöglicht es Mobiltelefonen, Computern und anderen Geräten, offline zu arbeiten.
- Die Umgebungsenergiewandler ermöglichen es Ihnen, mindestens 2 Jahre offline zu arbeiten. - Bei Bedarf kann die Lebensdauer des Umgebungsenergiegeräts verlängert werden.
- Keine Kosten bei der Stromerzeugung - die Umgebungsenergiewandler werden unabhängig voneinander aufgeladen und absorbieren die Energie der Umgebung.
- Niedrige Produktionskosten von Netzteilen - bei allen führenden Positionen von Umgebungsenergiewandlern übersteigen die Produktionskosten der Umgebungsenergiewandler nicht die Kosten für die Herstellung herkömmlicher Batterien (Batterien und Akkumulatoren).
- Unbegrenzte Möglichkeiten ihrer Gestaltung - von traditionellen Formen in Form von allgemein akzeptierten galvanischen Zellen bis hin zu den notwendigen Formen, die durch die Besonderheiten ihrer Anwendung bestimmt werden.
- Installationen können multipliziert und geteilt werden, wodurch die notwendigen Parameter geschaffen werden, um unterschiedliche Anforderungen zu lösen - was es den Umgebungsenergiewandlern ermöglicht, in verschiedenen Geräten verwendet zu werden und alle Anforderungen zu erfüllen, die für einen komfortablen Betrieb der jeweiligen Geräte erforderlich sind.
- Die Umgebungsenergiewandler sind kurzschlussresistent. Kurzschlüsse haben keinen Einfluss auf den weiteren Arbeitsablauf von Umgebungsenergiewandlern, da sie auch nach mehreren Kurzschlüssen fast sofort die gleiche Leistung bereitstellen.
- Lange Lebensdauer ohne vorbeugende Wartung, - Aufgrund des Fehlens beweglicher Teile und Teile muss der Umgebungsenergiewandler nicht gewartet werden.
- Ein vielfältiger Bereich von Geräteanwendungen, der von Batterien in Hörgeräten, Telefonen, Computern, Taschenlampen von Bergleuten, Autobatterien bis hin zu Beleuchtung und Raumheizung reicht.
- Absolute Kommunikationsfähigkeiten - angesichts des größten Spektrums an umwandelbarer Energie der Umgebung ist es möglich, die Umgebungsenergiewandler unter allen vorhandenen Bedingungen und in verschiedenen Richtungen zu verwenden, in denen Stromquellen benötigt werden.
- Die neue Technologie ermöglicht es, den für Haushaltsgeräte erforderlichen Strom auf technologisch fortschrittliche und kostengünstige Weise zu erzeugen.
- Die vorgeschlagene Technologie ist absolut unabhängig und autonom für den Langzeitbetrieb - die Umgebungsenergiewandler müssen nicht mit Kraftstoff oder elektrischem Strom aufgeladen werden
- Die Entsorgung gefährlicher Abfälle ist nicht erforderlich - die völlige Abwesenheit von Abfällen und der Bedarf an herkömmlichem Brennstoff usw. -, was den Betrieb der Umgebungsenergiewandler umweltfreundlich macht.
- Ein effektiver Vorteil der vorgeschlagenen Umgebungsenergiewandler besteht darin, dass sie in der Lage sein werden, den Betrieb aller Geräte im autonomen Modus zu gewährleisten - was an Orten fernab der Zivilisation sowie unter militärischen und touristischen Bedingungen von entscheidender Bedeutung sein wird.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Ansprüchen beinhaltet, auch wenn dieses Merkmal oder diese Kombination selbst nicht explizit in den Ansprüchen oder Ausführungsbeispielen angegeben ist.

Die Erfindung ist insbesondere im Bereich der Herstellung und dem Betrieb von Anlagen und Vorrichtungen zur Bereitstellung elektrischer Energie gewerblich anwendbar, wo beispielsweise fern von einer Anschlussmöglichkeit an ein Stromnetz elektrische Verbraucher mit Elektrizität versorgt werden müssen.

Die Erfindung wurde unter Bezugnahme auf bevorzugte Ausführungsformen beschrieben. Es ist jedoch für einen Fachmann vorstellbar, dass Abwandlungen oder Änderungen der Erfindung gemacht werden können, ohne dabei den Schutzbereich der nachstehenden Ansprüche zu verlassen.

## Patentansprüche

1. Verfahren zur Herstellung eines Umgebungsenergiewandlers umfassend ein plattenförmiges Trägersubstrat aus einem ersten Leitermaterial als erste Elektrode und einen auf dieser angeordneten Schichtaufbau mit einer Schicht ferroelektrischen Materials und einer Schicht eines von dem ersten Leitermaterial verschiedenen zweiten Leitermaterials als zweite Elektrode, wobei:
- die beiden Leitermaterialien unterschiedliche Konzentrationen freier Elektronen aufweisen,
- das ferroelektrische Material einen oder mehrere ferroelektrische Halbleiter umfasst, und
- ferroelektrische Halbleiter, die als ferroelektrisches Material verwendet werden, aus der Liste von Natriumnitrit, Halbleiterkeramiken auf Basis von Bariumtitanat, Lithiumniobat, Kaliumniobat, Bleititanat, etc. ausgewählt sind,
umfassend die Verfahrensschritte:
- Bereitstellung einer Platte aus dem für die erste Elektrode vorgesehenen Leitermaterial als Trägersubstrat,
- Unterziehung des Trägersubstrats mindestens einer Oberflächenbehandlung,
- Auftragen der Schicht ferroelektrischen Materials (BTO-Schicht), auf eine als Vorderseite vorgesehene Seite des Trägersubstrats,
- Maskierung zumindest der Ränder der BTO-Schicht auf der Vorderseite des Trägersubstrats unter Freihaltung mindestens einer innerhalb der Ränder der BTO-Schicht befindlichen Partie,
- Auftragen des für die zweite Elektrode vorgesehenen Leitermaterials auf die von der Maskierung freigehaltene Partie.

2. Verfahren nach Anspruch 1, wobei nach dem Auftragen der Schicht ferroelektrischen Materials (BTO-Schicht) auf die als Vorderseite vorgesehene Seite des Trägersubstrats, und vor dem Auftragen des für die zweite Elektrode vorgesehenen Leitermaterials auf die von der Maskierung freigehaltene Partie eine Überprüfung der BTO-Schicht zumindest innerhalb der von der Maskierung freigehaltenen Partie auf zumindest abschnittsweise Homogenität ihrer Schichtdicke und/oder zumindest abschnittsweise geschlossene Abdeckung des Trägersubstrats vorgenommen wird.

3. Verfahren nach Anspruch 1 oder 2, wobei als ein zusätzlicher Verfahrensschritt vor dem Auftragen des für die zweite Elektrode vorgesehenen Leitermaterials auf die von der Maskierung freigehaltene Partie die BTO-Schicht dotiert wird.

4. Verfahren nach Anspruch 1 oder 2, wobei als ein zusätzlicher Verfahrensschritt vor dem Auftragen der BTO-Schicht das für die BTO-Schicht vorgesehene ferroelektrische Materials dotiert wird.

5. Verfahren nach einem der Ansprüche 1 bis 4, wobei das Auftragen des ferroelektrischen Materials und/oder das Auftragen des für die zweite Elektrode vorgesehenen Leitermaterials durch Gasphasenabscheidung erfolgt.

6. Verfahren nach Anspruch 5, wobei eine physikalische Gasphasenabscheidung (PVD) als Methode zur Gasphasenabscheidung angewendet wird.

7. Verfahren nach einem der voranstehenden Ansprüche, wobei eine als Rückseite vorgesehene Seite des Trägersubstrats einer Oberflächenbehandlung in Strahltechnik unterzogen wird.

8. Verfahren nach einem der voranstehenden Ansprüche, wobei als Oberflächenbehandlung das Trägersubstrat entfettet wird.

9. Verfahren nach einem der voranstehenden Ansprüche, wobei Nickel (Ni), Silber (AG), Messing, Aluminium (Al), legiertes Eisen (Fe), insbesondere Stahl, als Leitermaterialien Anwendung finden, wobei unterschiedliches Leitermaterial für die erste und für die zweite Elektrode Anwendung finden.

10. Verfahren nach einem der voranstehenden Ansprüche, wobei zumindest Teile des Verfahrens unter Vakuumbedingungen, besonders vorteilhaft unter Hochvakuumbedingungen stattfinden.

11. Verfahren nach einem der voranstehenden Ansprüche, wobei zumindest Teile des Verfahrens unter einer Inertgasatmosphäre, besonders bevorzugt unter einer Edelgasatmosphäre stattfinden.

12. Verfahren nach einem der voranstehenden Ansprüche, wobei mindestens ein Trägersubstrat auf einer auch als Carrier bezeichneten Vorrichtung angeordnet wird, um die in den verschiedenen Verfahrensschritten vorgesehenen Behandlungsschritte zu durchlaufen beziehungsweise nacheinander auszuführen.

13. Verfahren nach einem der voranstehenden Ansprüche, wobei der Umgebungsenergiewandler in ein Gehäuse 1 eingesetzt wird.
